# FASCICULE DE BREVET EUROPEEN

(11) **EP 2 963 427 B1**
(45) Date de publication et mention de la délivrance du brevet: **13.01.2021**
(21) Numéro de dépôt: 15172615.5
(22) Date de dépôt: 17.06.2015
(51) Int. Cl.: G01R 11/24, G01R 22/06

(54) **COMPTEUR ÉLECTRONIQUE À IMMUNITÉ MAGNÉTIQUE**
ELEKTRONISCHER ZÄHLER MIT IMMUNITÄT GEGEN MAGNETISCHE INTERFERENZEN
ELECTRONIC COUNTER WITH MAGNETIC IMMUNITY

(30) Priorité: 30.06.2014 FR 1456223
(43) Date de publication de la demande: 06.01.2016
(73) Titulaire: SAGEMCOM ENERGY & TELECOM SAS, 92500 Rueil-Malmaison (FR)
(72) Inventeur: Grincourt, Christophe, 92500 RUEIL MALMAISON (FR)
(74) Mandataire: Lavialle, Bruno François Stéphane

(56) Documents cités:
- EP-A1- 1 936 389
- WO-A2-2008/065291
- DE-U1-202004 017 886
- FR-A1- 2 701 122

## Description

L'invention concerne le domaine des compteurs électroniques, par exemple du type communément appelé compteur électrique, et la protection de ces compteurs contre des opérations frauduleuses consistant à perturber le fonctionnement des compteurs à l'aide d'un aimant.

### ARRIERE PLAN DE L'INVENTION

Les compteurs électriques modernes sont des compteurs électroniques qui sont bien sûr adaptés à mesurer une quantité d'énergie électrique consommée dans une habitation ou dans un lieu quelconque et à afficher cette mesure, mais qui sont aussi capable de réaliser un certain nombre de fonctions complémentaires : gestion des tarifs par réception d'ordres, relève et programmation à distance, télé-information client, etc.

Les compteurs électroniques comportent au moins une carte électronique comprenant un certain nombre de composants électroniques. Ces composants électroniques sont, pour certains, destinés à réaliser les fonctions évoquées plus tôt, et pour d'autres, utilisés pour gérer le fonctionnement de la carte électronique : composants d'alimentation, de protection contre des surtensions ou des perturbations électromagnétiques, etc.

Certains abonnés tentent frauduleusement de perturber le fonctionnement de leur compteur électronique en utilisant de puissants aimants qu'ils utilisent de manière à fausser la mesure de l'énergie électrique, à couper de manière intermittente ou continue l'alimentation de la carte électronique, ou à empêcher le compteur électronique de communiquer au fournisseur d'énergie électrique des informations sur la consommation d'énergie. Cette pratique bénéficie du développement de la commercialisation d'aimants de taille relativement réduite capables de générer un champs magnétique très important, tels que les aimants en néodyme. Ces aimants agissent principalement sur des composants inductifs de la carte électronique, par exemple sur des transformateurs utilisés pour la mesure de l'énergie électrique consommée, sur des transformateurs utilisés dans une alimentation de la carte, sur des transformateurs utilisés dans des interfaces de communication (typiquement des interfaces Courants Porteurs en Ligne, ou CPL), sur des inductances diverses, etc. Le champ magnétique généré par l'aimant sature les bobines des composants inductifs dont la valeur inductive s'effondre et dont le comportement électrique s'apparente alors à celui d'un fil (court-circuit).

La solution privilégiée actuellement pour limiter ce type de fraude consiste à équiper les composants inductifs d'un blindage. Cependant, l'utilisation de blindages tend à augmenter de manière significative d'une part, le coût du composant blindé, et d'autre part, la taille du composant blindé et donc éventuellement de la carte électronique et même du compteur. Le document DE 2004 017886 U1 divulgue un tel compteur électrique.

### OBJET DE L'INVENTION

L'invention a pour objet de protéger un compteur électronique contre une opération frauduleuse consistant à perturber le fonctionnement du compteur à l'aide d'un aimant, sans pour autant augmenter significativement le coût et la taille du compteur.

### RESUME DE L'INVENTION

En vue de la réalisation de ce but, on propose un compteur électronique de type compteur électrique, comportant un boîtier comprenant au moins une face sensiblement plane et contenant au moins une carte électronique sensiblement perpendiculaire à la face sensiblement plane, la carte électronique étant pourvue d'au moins un composant inductif ayant un enroulement de fil conducteur autour d'un axe d'enroulement sensiblement parallèle à la carte électronique. Selon l'invention, le composant inductif est monté sur la carte de telle manière que l'axe d'enroulement s'étende obliquement par rapport à la face sensiblement plane.

Pour perturber un compteur électronique classique, l'opération la plus efficace consiste à plaquer un aimant sur une face sensiblement plane du compteur et à déplacer l'aimant jusqu'à ce que l'axe de celui-ci soit confondu avec l'axe d'enroulement d'un composant inductif. C'est en effet dans cette configuration que l'effet de l'aimant sur le comportement du composant inductif est le plus important, et donc que l'aimant est le plus efficace pour perturber le fonctionnement du compteur.

Dans le compteur électronique de l'invention, comme l'axe d'enroulement du composant inductif s'étend obliquement par rapport à la face sensiblement plane, l'aimant doit lui-même être incliné par rapport à ladite face pour que son axe soit confondu avec l'axe d'enroulement du composant inductif. L'inclinaison de l'aimant revient à éloigner le centre de l'aimant du boîtier et donc du composant inductif, et donc à diminuer de manière importante l'effet de l'aimant sur le comportement du composant inductif. Il devient de plus beaucoup plus compliqué pour un fraudeur de réussir à aligner l'axe de l'aimant et l'axe d'enroulement. On limite ainsi fortement le risque que l'utilisation d'un aimant puisse perturber le fonctionnement du compteur, sans pour autant augmenter significativement le coût et la taille du compteur.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :
- la figure 1 est une vue en perspective du compteur électronique de l'invention, ladite vue étant écorchée pour rendre visible une carte électronique du compteur ;
- la figure 2 est une vue en coupe simplifiée du compteur électronique de l'invention, ladite coupe étant pratiquée dans un plan parallèle à celui de la carte électronique ;
- la figure 3 est une vue analogue à celle de la figure 2 pour un compteur électronique de l'art antérieur.

### DESCRIPTION DETAILLEE DE L'INVENTION

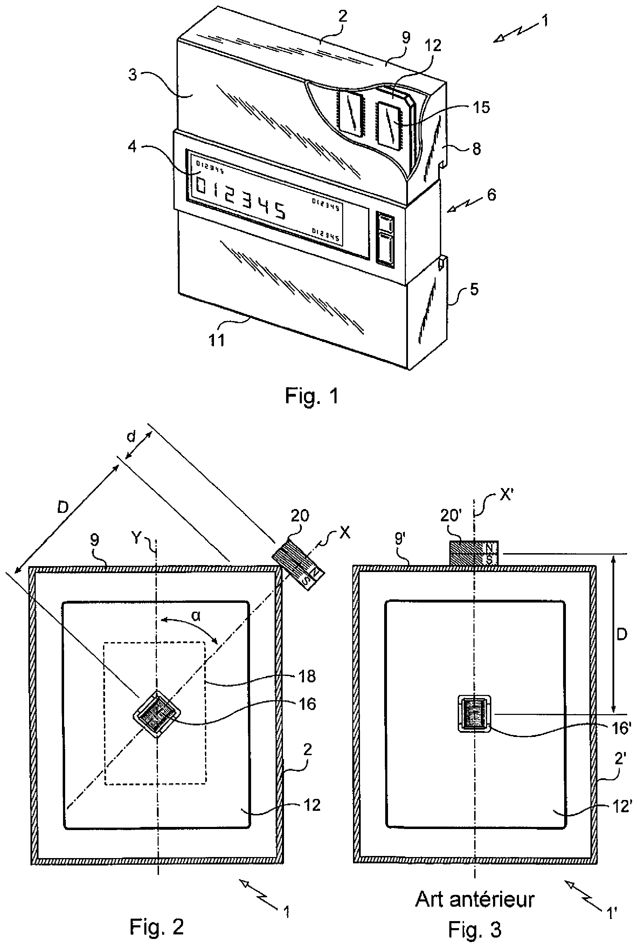

En référence aux figures 1 et 2, le compteur électronique de l'invention est ici un compteur électrique 1 destiné à mesurer une quantité d'énergie électrique consommée dans une habitation et à afficher cette mesure. Le compteur électrique 1 est aussi adapté à réaliser un certain nombre de fonctions complémentaires : gestion des tarifs par réception d'ordres, relève et programmation à distance, télé-information client, etc.

Le compteur électrique 1 comporte un boîtier 2 de forme sensiblement parallélépipédique, c'est-à-dire que la forme générale du boîtier 2 est parallélépipédique mais que le boîtier 2 peut comporter des parties légèrement saillantes ou enfoncées. Le boîtier 2 du compteur électrique 1 comprend une face avant 3 munie d'un affichage LCD 4 permettant d'afficher les mesures de la quantité d'énergie électrique consommée par l'habitation, une face arrière 5 munie de moyens de fixation 6 destinés à fixer le boîtier 2 à un mur de l'habitation, deux faces latérales 8, une face supérieure 9 et une face inférieure 11. Chacune de ces faces est sensiblement plane, c'est-à-dire, à nouveau, que la forme générale de chaque face est plane mais que chaque face peut comporter des parties légèrement saillantes ou enfoncées.

Le boîtier 2 contient une carte électronique 12 positionnée sensiblement perpendiculairement par rapport à la face supérieure 9 et à la face inférieure 11. La carte électronique 12 est située dans le fond du boîtier à proximité de la face arrière 5 du boîtier 2. Par « à proximité », on entend que la carte électronique 12 est située le plus proche possible de cette face arrière 5, en tenant bien sûr compte des différents éléments empêchant de plaquer la carte électronique 12 contre la face arrière 5 : éléments mécaniques rapportés sur ladite face arrière 5, composants de la carte 12, connecteurs, passage de fils électriques, etc.

La carte électronique 12 comporte un certain nombre de composants électroniques 15. Ces composants électroniques 15 comprennent notamment des composants d'alimentation formant un module d'alimentation, en l'occurrence une alimentation à découpage, destiné à alimenter les composants de la carte électronique 12 et l'afficheur LCD 4. Ces composants d'alimentation comprennent notamment un transformateur 16 comprenant deux bobines formées chacune par un enroulement de fil conducteur autour d'un même axe d'enroulement X. L'axe d'enroulement X est sensiblement parallèle à la carte électronique 12. Le transformateur 16 est ici positionné à une certaine distance des bords de la carte électronique 12, en l'occurrence dans une partie centrale 18 de la carte électronique 12, ladite partie centrale 18 présentant une surface de préférence inférieure à 80% de la surface totale de la carte électronique 12.

Le transformateur 16 est monté sur la carte électronique 12 de telle manière que l'axe d'enroulement X s'étende obliquement par rapport à la face supérieure 9. L'axe d'enroulement X forme ici un angle α d'environ 45° avec un axe perpendiculaire Y à la face supérieure 9. Par environ 45°, on entend ici un angle compris entre 40° et 50°.

Pour bien comprendre les avantages associés à ce positionnement, on se réfère à la figure 3 qui représente un compteur électrique 1' de l'art antérieur. Le compteur électrique 1' de l'art antérieur comporte lui aussi un boîtier 2' contenant une carte électronique 12' pourvue d'une alimentation à découpage et d'un transformateur 16' semblable au transformateur 16 du compteur électrique 1 de l'invention. Le transformateur 16' est ici monté classiquement sur la carte électronique 12' de telle manière que son axe d'enroulement X' s'étende perpendiculairement par rapport à la face supérieure 9' du boîtier 2'. En positionnant correctement un aimant 20' sur la face supérieure 9', de manière à ce que l'axe de l'aimant soit confondu avec l'axe d'enroulement X' du transformateur 16', on se place facilement dans la configuration dans laquelle l'effet de l'aimant 20' sur le comportement du transformateur 16' est le plus important. La distance entre le centre de l'aimant 20' et le centre du transformateur 16' est égale à une longueur D.

En revenant à la figure 2, on constate que, dans le cas du compteur électrique 1 de l'invention, du fait de l'orientation du transformateur 16, il est nécessaire d'incliner un aimant 20 par rapport à la face supérieure 9 pour que l'axe de l'aimant 20 soit confondu avec l'axe d'enroulement X. Ainsi, lorsque l'axe de l'aimant 20 et l'axe d'enroulement X sont confondus, la distance entre le centre de l'aimant 20 et le centre du transformateur 16 est supérieure d'une distance d à la longueur D. Le champ magnétique perçu au niveau du transformateur 16 est donc nettement réduit et l'effet de l'aimant 20 sur le comportement du transformateur 16 est beaucoup moins important que dans le cas de l'aimant 20' et du transformateur 16' du compteur 1'. De plus, un fraudeur souhaitant aligner l'axe de l'aimant 20 avec l'axe d'enroulement X ne peut se contenter de poser à plat l'aimant 20 sur une face supérieure du boîtier 2 et est obligé d'essayer de positionner l'aimant 20 de manière aléatoire pour tenter de reproduire, avec l'aimant 20, l'angle α.

L'invention n'est pas limitée au mode de mise en œuvre particulier qui vient d'être décrit, mais, bien au contraire, couvre toute variante entrant dans le cadre de l'invention telle que définie par les revendications.

Bien que le compteur électronique ici décrit soit un compteur électrique destiné à mesurer une quantité d'énergie électrique, l'invention est applicable à tout type de compteur électronique (compteur de gaz, etc.).

L'angle d'inclinaison peut être différent de l'angle indiqué ici. Cet angle peut être choisi en fonction de la forme du boîtier, par exemple pour aligner l'axe de l'enroulement avec une diagonale du boîtier lorsque le boîtier est rectangulaire.

Bien que l'on ait décrit un compteur comportant un boîtier de forme sensiblement parallélépipédique, l'invention s'applique à tout type de compteur comprenant au moins une face sensiblement plane et contenant au moins une carte électronique sensiblement perpendiculaire à la face sensiblement plane.

Bien que l'on ait indiqué que le composant inductif est un transformateur utilisé dans une alimentation à découpage, l'invention s'applique à tout type de composant inductif (transformateur, inductance, etc.) pour lequel un axe d'enroulement de fil conducteur peut être défini, ledit composant inductif pouvant être utilisé dans tout type de circuit (circuit d'alimentation, de mesure, de protection contre des perturbations ou agressions diverses, module de communication de type CPL, etc.).

## Revendications

1. Compteur électronique de type compteur électrique, comportant un boîtier (2) comprenant au moins une face sensiblement plane (9) et contenant au moins une carte électronique (12) sensiblement perpendiculaire à la face sensiblement plane, la carte électronique (12) étant pourvue d'au moins un composant inductif (16) ayant un enroulement de fil conducteur autour d'un axe d'enroulement (X) sensiblement parallèle à la carte électronique (12), **caractérisé en ce que** le composant inductif (16) est monté sur la carte (12) de telle manière que l'axe d'enroulement (X) s'étende obliquement par rapport à la face sensiblement plane (9).

2. Compteur électronique selon la revendication 1, dans lequel l'axe d'enroulement (X) forme un angle compris entre 40° et 50° avec un axe perpendiculaire (Y) à la face sensiblement plane.

3. Compteur électronique selon l'une des revendications précédentes, dans lequel le composant inductif (16) est situé dans une zone centrale (18) de la carte électronique.

4. Compteur électronique selon l'une des revendications précédentes, dans lequel le composant inductif (16) est un transformateur destiné à mesurer un courant électrique.

5. Compteur électronique selon l'une des revendications 1 à 3, dans lequel le composant inductif (16) est un transformateur utilisé dans un module d'alimentation de la carte électronique.

6. Compteur électronique selon l'une des revendications 1 à 3, dans lequel le composant inductif (16) est un transformateur utilisé dans un module de communication de type Courants Porteurs en Ligne dudit compteur.

7. Compteur électronique selon l'une des revendications 1 à 3, dans lequel le composant inductif est une inductance.

8. Compteur électronique selon l'une des revendications précédentes, dans lequel le boîtier (2) est de forme sensiblement parallélépipédique.

9. Compteur électronique selon l'une des revendications précédentes, dans lequel la carte électronique (12) est située à proximité d'une face de fixation (5) du compteur électronique.

## Patentansprüche

1. Elektronischer Zähler vom Typ Stromzähler, umfassend ein Gehäuse (2), das mindestens eine im Wesentlichen ebene Fläche (9) umfasst und mindestens eine Elektronikkarte (12) enthält, die im Wesentlichen senkrecht zur im Wesentlichen ebenen Fläche ist, wobei die Elektronikkarte (12) mit mindestens einem induktiven Bauelement (16) versehen ist, das eine Wicklung aus Leitungsdraht um eine Wicklungsachse (X) hat, die im Wesentlichen parallel zur Elektronikkarte (12) ist, **dadurch gekennzeichnet, dass** das induktive Bauelement (16) auf der Karte (12) derart angebracht ist, dass die Wicklungsachse (X) in Bezug auf die im Wesentlichen ebene Fläche (9) schräg verläuft.

2. Elektronischer Zähler nach Anspruch 1, bei dem die Wicklungsachse (X) einen Winkel zwischen 40° und 50° mit einer Achse (Y) bildet, die senkrecht zur im Wesentlichen ebenen Fläche ist.

3. Elektronischer Zähler nach einem der vorhergehenden Ansprüche, bei dem sich das induktive Bauelement (16) in einer zentralen Zone (18) der Elektronikkarte befindet.

4. Elektronischer Zähler nach einem der vorhergehenden Ansprüche, bei dem das induktive Bauelement (16) ein Transformator ist, der dazu bestimmt ist, einen elektrischen Strom zu messen.

5. Elektronischer Zähler nach einem der Ansprüche 1 bis 3, bei dem das induktive Bauelement (16) ein Transformator ist, der in einem Versorgungsmodul der Elektronikkarte verwendet wird.

6. Elektronischer Zähler nach einem der Ansprüche 1 bis 3, bei dem das induktive Bauelement (16) ein Transformator ist, der in einem Kommunikationsmodul des Zählers vom Typ Powerline-Kommunikationsmodul verwendet wird.

7. Elektronischer Zähler nach einem der Ansprüche 1 bis 3, bei dem das induktive Bauelement ein induktiver Widerstand ist.

8. Elektronischer Zähler nach einem der vorhergehenden Ansprüche, bei dem das Gehäuse (2) eine im Wesentlichen parallelepipedische Form hat.

9. Elektronischer Zähler nach einem der vorhergehenden Ansprüche, bei dem sich die Elektronikkarte (12) in der Nähe einer Befestigungsfläche (5) des elektronischen Zählers befindet.

## Claims

1. An electronic meter of the electricity meter type, including a housing (2) comprising at least one substantially plane face (9) and containing at least one electronic circuit card (12) substantially perpendicular to the substantially plane face, the circuit card (12) being provided with at least one inductive component (16) having a winding of conductive wire around a winding axis (X) that is substantially parallel to the circuit card (12), the meter being **characterized in that** the inductive component (16) is mounted on the card (12) in such a manner that the winding axis (X) extends obliquely relative to the substantially plane face (9).

2. An electronic meter according to claim 1, wherein the winding axis (X) forms an angle lying in the range 40° to 50° with an axis (Y) perpendicular to the substantially plane face.

3. An electronic meter according to either preceding claim, wherein the inductive component (16) is situated in a central zone (18) of the circuit card.

4. An electronic meter according to any preceding claim, wherein the inductive component (16) is a transformer for measuring an electric current.

5. An electronic meter according to any one of claims 1 to 3, wherein the inductive component (16) is a transformer used in a power supply module of the circuit card.

6. An electronic meter according to any one of claims 1 to 3, wherein the inductive component (16) is a transformer used in a power-line carrier type communication module of said meter.

7. An electronic meter according to any one of claims 1 to 3, wherein the inductive component is an inductor.

8. An electronic meter according to any preceding claim, wherein the housing (2) is substantially in the shape of a rectangular parallelepiped.

9. An electronic meter according to any preceding claim, wherein the circuit card (12) is situated in the proximity of a fastener face (5) of the electronic meter.
